(19) Europäisches Patentamt
European Patent Office
Office européen des brevets

(11) **EP 4 456 412 A1**

(12) **EUROPEAN PATENT APPLICATION**

(43) Date of publication:
**30.10.2024 Bulletin 2024/44**

(21) Application number: **24171760.2**

(22) Date of filing: **22.04.2024**

(51) International Patent Classification (IPC):
**H02P 21/16** (2016.01)     **H02P 23/14** (2006.01)

(52) Cooperative Patent Classification (CPC):
**H02P 23/14; H02P 21/16**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **23.04.2023 CN 202310443919**

(71) Applicant: **Carrier Corporation**
**Palm Beach Gardens, FL 33418 (US)**

(72) Inventors:
• **CHEN, Kun**
 **Shanghai 201206 (CN)**
• **ZHANG, Zhenyu**
 **Shanghai 201206 (CN)**
• **AGIRMAN, Ismail**
 **Palm Beach Gardens 33418 (US)**

(74) Representative: **Dehns**
 **St. Bride's House**
 **10 Salisbury Square**
 **London EC4Y 8JD (GB)**

(54) **DETECTION METHOD AND APPARATUS FOR MOTOR PARAMETERS**

(57)     A method (1000) for detecting motor parameters, comprises: injecting (110) a first direct current signal; receiving (120) a first d-q axis feedback current corresponding to the first direct current signal and a first d-q axis voltage output by a current regulation module; injecting (130) a second direct current signal different from the first direct current signal; receiving (140) a second d-q axis feedback current corresponding to the second direct current signal and a second d-q axis voltage output by the current regulation module; and determining (150) motor parameters based on the first d-q axis feedback current, the first d-q axis voltage, the second d-q axis feedback current and the second d-q axis voltage. Also disclosed is an apparatus (2000) for detecting motor parameters, a computer program product and an air conditioner compressor system.

**1000**

S110

S120

S130

S140

S150

FIG.1

EP 4 456 412 A1

## Description

### FIELD OF THE INVENTION

The present application relates to the field of motor parameter detection, and more specifically, to a method for detecting motor parameters, an apparatus for detecting motor parameters, a computer program product, and an air-conditioning compressor system.

### BACKGROUND

The motor used in the inverter air conditioner industry is a permanent magnet synchronous motor (referred to as PMSM), and the control algorithm of the permanent magnet synchronous motor is generally a vector control algorithm, that is, a field-oriented control algorithm (referred to as FOC). The vector control algorithm can be composed of coordinate transformation, current sampling and reconstruction, position estimation, speed loop regulator, current loop regulator, and space vector modulation (SVPWM for short), for example.

The accuracy of PMSM parameters will directly determine the performance and stability of vector control. But in most PMSM-driven applications, the motor parameters are unknown and will change with age. The existing motor parameter detection methods need to rotate the rotor and use complex algorithms to detect parameters, which is inconvenient to operate.

### SUMMARY OF THE INVENTION

According to a first aspect of the present invention, a method for detecting motor parameters is provided. The method comprises: injecting a first direct current signal; receiving a first d-q axis feedback current corresponding to the first direct current signal and a first d-q axis voltage output by a current regulation module; injecting a second direct current signal different from the first direct current signal; receiving a second d-q axis feedback current corresponding to the second direct current signal and a second d-q axis voltage output by the current regulation module; and determining motor parameters based on the first d-q axis feedback current, the first d-q axis voltage, the second d-q axis feedback current and the second d-q axis voltage.

Optionally, the motor is a permanent magnet synchronous motor and the current regulation module is a PI controller.

Optionally, both the first direct current signal and the second direct current signal are positive currents on the d-axis.

Optionally, the motor parameters include a stator resistance $R_s$, wherein the stator resistance $R_s$ is determined according to the following formula: $R_s =$

$\dfrac{V_{dc1} - V_{dc2}}{i_{dc1} - i_{dc2}}$ , wherein $V_{dc1}$ is a d-axis voltage in the first d-q axis voltage, $V_{dc2}$ is a d-axis voltage in the second d-q axis voltage, $i_{dc1}$ is a d-axis feedback current value in the first d-q axis feedback current, and $i_{dc2}$ is a d-axis feedback current value in the second d-q axis feedback current, and $i_{dc1} > i_{dc2}$.

Optionally, the motor parameters include permanent magnet flux linkage $\lambda_m$, wherein the permanent magnet flux linkage $\lambda_m$ is determined according to the following formula: $\lambda_m = \dfrac{V_{rated} - I_{rated} * R_s}{2 * \pi * f_{rated}}$ , wherein $V_{rated}$ is a rated voltage of the permanent magnet synchronous motor, $I_{rated}$ is a rated current of the permanent magnet synchronous motor, and $f_{rated}$ is a rated frequency of the permanent magnet synchronous motor.

Optionally, the above method also comprises: injecting a third signal, the third signal being a sinusoidal signal with a certain frequency and amplitude applied on the d-axis; receiving a third d-axis voltage output by the current regulation module, the third d-axis voltage being corresponding to the third signal; and determining a d-axis inductance $L_d$ according to the third d-axis voltage.

Optionally, the third signal is represented by the following formula: $i_{hd} = i_d + i_{h1}\sin(2 * \pi * f_{h1} * t)$, wherein $i_{hd}$ is the third signal, $i_d$ is a DC offset on the d-axis, $i_{h1}$ is an amplitude of the sinusoidal signal, and $f_{h1}$ is a frequency of the sinusoidal signal.

Optionally, the d-axis inductance $L_d$ is determined according to the following formula: $L_d = \dfrac{V_{hd}}{2 * \pi * f_{h1} * i_{h1}}$ , wherein $V_{hd}$ is the third d-axis voltage.

Optionally, the above method also comprises: injecting a fourth signal, the fourth signal being a sinusoidal signal with a certain frequency and amplitude applied on the q-axis; receiving a fourth q-axis voltage output by the current regulation module, the fourth q-axis voltage being corresponding to the fourth signal; and determining a q-axis inductance $L_q$ according to the fourth q-axis voltage, wherein the fourth signal is represented by the following formula: $i_{hq} = i_{h2}\sin(2 * \pi * f_{h2} * t)$, wherein $i_{hq}$ is the fourth signal, $i_{h2}$ is an amplitude of the sinusoidal signal, and $f_{h2}$ is a frequency of the sinusoidal signal, wherein the q-axis inductance $L_q$ is determined according to the following formula: $L_q = \dfrac{V_{hq}}{2 * \pi * f_{h2} * i_{h2}}$ , wherein $V_{hq}$ is the fourth q-axis voltage.

According to a second aspect of the present invention, an apparatus for detecting motor parameters is provided. The apparatus comprises: a first receiving device for receiving a first d-q axis feedback current corresponding to an injected first direct current signal and a first d-q axis voltage output by a current regulation module; a second receiving device for receiving a second d-q axis feedback current corresponding to an injected second direct current signal and a second d-q axis voltage output by the current regulation module; and a determining device for determining the motor parameters based on the first d-q axis feedback current, the first d-q axis voltage, the second d-q axis feedback current and the second d-q axis voltage. The apparatus may be termed a motor parameter detection apparatus. The apparatus may be configured to detect motor parameters.

Optionally, the motor is a permanent magnet synchronous motor and the current regulation module is a PI controller, and both the first direct current signal and the second direct current signal are positive currents on the d-axis.

Optionally, the motor parameters include a stator resistance $R_s$, wherein the determining device is configured to determine the stator resistance $R_s$ according to the following formula:

$$R_s = \frac{V_{dc1} - V_{dc2}}{i_{dc1} - i_{dc2}}$$

, wherein $V_{dc1}$ is a d-axis voltage in the first d-q axis voltage, $V_{dc2}$ is a d-axis voltage in the second d-q axis voltage, $i_{dc1}$ is a d-axis feedback current value in the first d-q axis feedback current, and $i_{dc2}$ is a d-axis feedback current value in the second d-q axis feedback current, and $i_{dc1} > i_{dc2}$.

Optionally, the motor parameters include permanent magnet flux linkage $\lambda_m$, wherein the determining device is configured to determine the permanent magnet flux linkage $\lambda_m$ according to the following formula:

$$\lambda_m = \frac{V_{rated} - I_{rated} * R_s}{2 * \pi * f_{rated}}$$

, wherein $V_{rated}$ is a rated voltage of the permanent magnet synchronous motor, $I_{rated}$ is a rated current of the permanent magnet synchronous motor, and $f_{rated}$ is a rated frequency of the permanent magnet synchronous motor.

Optionally, the above apparatus further comprises: a third receiving device for receiving a third d-axis voltage output by the current regulation module, the third d-axis voltage being corresponding to the third signal which is a sinusoidal signal with a certain frequency and amplitude applied on the d-axis; and the determining device is also configured to determine a d-axis inductance $L_d$ according to the third d-axis voltage.

Optionally, the third signal is represented by the following formula: $i_{hd} = i_d + i_{h1}\sin(2 * \pi * f_{h1} * t)$, wherein $i_{hd}$ is the third signal, $i_d$ is a DC offset on the d-axis, $i_{h1}$ is an amplitude of the sinusoidal signal, and $f_{h1}$ is a frequency of the sinusoidal signal, and wherein the determining device is further configured to determine the d-axis inductance $L_d$ according to the following formula:

$$L_d = \frac{V_{hd}}{2 * \pi * f_{h1} * i_{h1}}$$

, wherein $V_{hd}$ is the third d-axis voltage.

Optionally, the above apparatus further comprises: a fourth receiving device for receiving a fourth q-axis voltage output by the current regulation module, the fourth q-axis voltage being corresponding to an injected fourth signal which is a sinusoidal signal with a certain frequency and amplitude applied on the q-axis; and the determining device is further configured to determine a q-axis inductance $L_q$ according to the fourth q-axis voltage, wherein the fourth signal is represented by the following formula: $i_{hq} = i_{h2}\sin(2 * \pi * f_{h2} * t)$, wherein $i_{hq}$ is the fourth signal, $i_{h2}$ is an amplitude of the sinusoidal signal, and $f_{h2}$ is a frequency of the sinusoidal signal, wherein the q-axis inductance $L_q$ is determined according to the following formula: $L_q = \frac{V_{hq}}{2 * \pi * f_{h2} * i_{h2}}$ , wherein $V_{hq}$ is the fourth q-axis voltage.

According to another aspect of the present invention, a computer program product comprising a computer program is provided, wherein when the computer program is executed by a processor, the method according to the first aspect of the invention optionally including any of the optional features described above is implemented.

According to another aspect of the present invention, an air-conditioning compressor system is provided. The system comprises a permanent magnet synchronous motor; and the apparatus according to the second aspect of the invention optionally including any of the optional features described above, for detecting motor parameters of the permanent magnet synchronous motor.

BRIEF DESCRIPTION OF THE DRAWINGS

The above and other objects and advantages of the present invention will be more fully understood from the following detailed description which describes preferred embodiments of the present invention by way of example only and with reference to the accompanying drawings, wherein the same or similar elements are denoted by the same reference numerals.

FIG. 1 shows a schematic flow chart of a method for detecting motor parameters;

FIG. 2 shows a schematic structural diagram of an apparatus for detecting motor parameters;

FIG. 3 shows a schematic diagram of injecting signals into a system including an apparatus for detecting motor parameters;

FIG. 4 shows a waveform diagram of a signal injected into the d-q axis; and

FIG. 5 shows a d-q axis equivalent circuit diagram of a permanent magnet synchronous motor.

## DETAILED DESCRIPTION OF THE INVENTION

The present invention is described more fully hereinafter with reference to the accompanying drawings, in which illustrative embodiments of the invention are shown. However, the present invention may be embodied in different forms, and should not be construed as being limited to only the embodiments given herein. The above-mentioned embodiments are given to make the disclosure herein comprehensive and complete, so as to more fully convey the protection scope of the present invention to those skilled in the art, wherein the scope of the invention is defined by the appended claims.

In this specification, terms such as "comprising" and "including" mean that in addition to the units and steps that are directly and explicitly stated in the specification and claims, the technical solution of the application does not exclude the situation of other units and steps not directly or explicitly stated.

Terms such as "first" and "second" do not indicate the sequence of elements in terms of time, space, size, etc., but are only used to distinguish the elements unless otherwise specified.

According to some embodiments of the present invention, the detection scheme of the motor parameters is implemented by receiving the first d-q axis feedback current corresponding to the injected first direct current signal and the first d-q axis voltage, the second d-q axis feedback current corresponding to the injected second direct current signal and the second d-q axis voltage and determining motor parameters based on the first d-q axis feedback current, the first d-q axis voltage, the second d-q axis feedback current and the second d-q axis voltage. By using two DC signals, the influence of the dead zone (time) of the inverter can be effectively avoided, thereby ensuring the accuracy of the motor parameters. This scheme uses the current closed-loop structure of vector control to avoid the risk of overcurrent, and does not require additional hardware equipment.

In addition, in some embodiments of the present invention, both the first DC signal and the second DC signal are positive currents on the d-axis, which can effectively keep the rotor stationary (making the final measured motor parameters more accurate), and can avoid the risk of PMSM demagnetization.

Specific embodiments of the present invention are further described below with reference to the accompanying drawings. It should be noted that, in order to describe the content related to the present invention more clearly, some unnecessary features or circuit elements are not shown in the drawings. However, for those skilled in the art, this omission will not cause difficulty in implementing the technical solution described in the specification of this application.

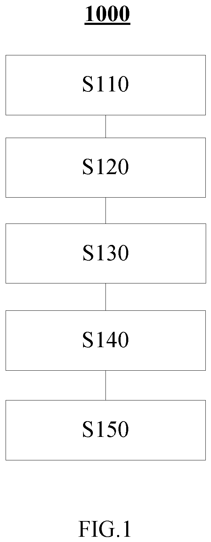

FIG. 1 shows a schematic flowchart of a method 1000 for detecting motor parameters according to an embodiment of the present invention. As shown in FIG. 1, the method 1000 includes the following steps:

in step 110, injecting a first direct current signal;

in step 120, receiving a first d-q axis feedback current corresponding to the first direct current signal and a first d-q axis voltage output by a current regulation module;

in step 130, injecting a second direct current signal different from the first direct current signal;

in step 140, receiving a second d-q axis feedback current corresponding to the second direct current signal and a second d-q axis voltage output by the current regulation module; and

in step 150, determining motor parameters based on the first d-q axis feedback current, the first d-q axis voltage, the second d-q axis feedback current and the second d-q axis voltage.

In the context of this application, the term "motor" may also be referred to as "electric motor", which is a device that converts electrical energy into mechanical energy. It uses the energized coil (that is, the stator winding) to generate a rotating magnetic field and acts on the rotor to form a magneto-electric force rotation torque. In one or more embodiments, the motor may be a permanent magnet synchronous motor PMSM.

The term "motor parameters" is used to denote parameters related to vector control of the motor. In one embodiment, the motor parameters include: stator resistance, inductance, and permanent magnet flux linkage.

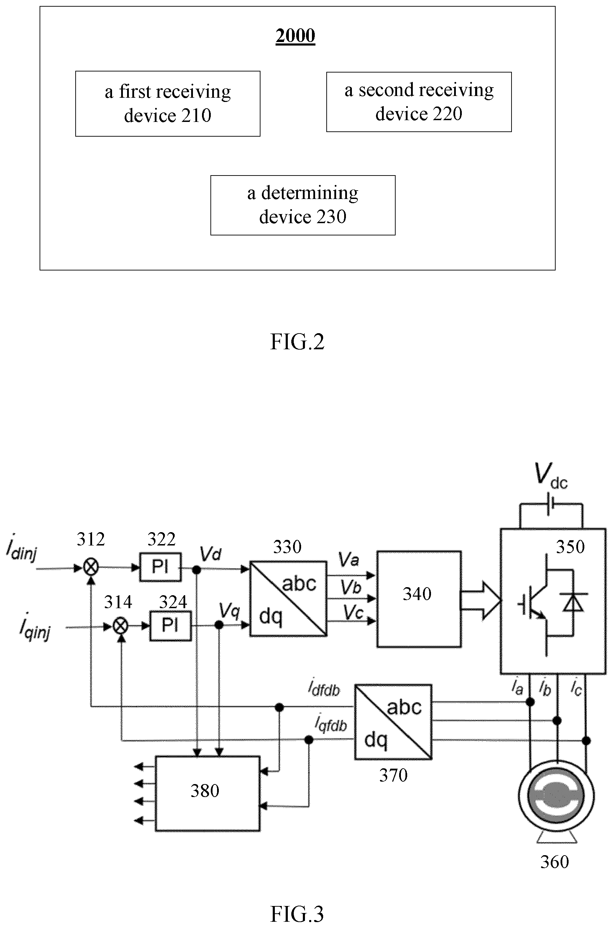

In step S 110 and step S130, the first direct current signal and the second direct current signal are respectively injected. Here, both the first DC signal and the second DC signal are injected into the input side of the current closed-loop control structure of the motor. For example, see FIG. 3, which shows a schematic diagram of signal injection and parameter detection according to an embodiment of the present invention. As shown in FIG. 3, the current closed-loop control structure consists of a first mixer 312, a second mixer 314, a first PI controller 322, a second PI controller 324, a first coordinate system transformation module 330, and a space vector modulation module 340, an inverter module 350, and a second coordinate system transformation module 370. $i_{dinj}$ represents the current injection signal of the d-axis, $i_{qinj}$ represents the current injection signal of the q-axis, wherein $i_{dinj}$ is applied to the first mixer 312 so as to be mixed with the d-axis feedback current $i_{dfdb}$ output by the second coordinate system transformation module 370; similarly, $i_{qinj}$ is applied to the second mixer 314 to be mixed with the q-axis feedback current $i_{qfdb}$ output by the second coordinate system transformation module 370. In the context of the present application, the injected first/second direct current signal is to be understood as the sum of the d-axis current injection signal and the q-axis current injection signal.

In one or more embodiments, the "current regulation module" is a PI controller, also known as a proportional-integral controller. Of course, those skilled in the art can understand that the current regulation module can also be a PID controller.

Referring to FIG. 3, in the first time period, $i_{dinj}$ and $i_{qinj}$ (that is, components of the first DC signal on the d-axis and q-axis) are respectively injected into the input terminals of the first mixer 312 and the second mixer 314, thereby the first PI controller 322 outputting the first d-axis voltage Vd, the second PI controller 324 outputting the first q-axis voltage Vq, and the second coordinate system transformation module 370 outputting the first d-axis feedback current $i_{dfdb}$ and the first q-axis feedback current $i_{qfdb}$ and supplying them to the first mixer 312 and the second mixer 314 respectively. That is to say, the first d-axis voltage Vd and the first q-axis voltage Vq correspond to the injected first DC signal.

In the second time period (for example, the second time period is immediately after the first time period), a second DC signal different from the first DC signal (with different current vector values) is injected into the input terminals of the first mixer 312 and the second mixer 314. It should be noted that at this time $i_{dinj}$ and $i_{qinj}$ represent the components of the second DC signal on the d-axis and q-axis, so the first PI controller 322 outputs the second d-axis voltage Vd, the second PI controller 324 outputs the second q-axis voltage Vq, the second coordinate system transformation module 370 outputs the second d-axis feedback current $i_{dfdb}$ and the second q-axis feedback current $i_{qfdb}$, and provides them to the first mixer 312 and the second mixer 314 respectively. That is to say, the second d-axis voltage Vd and the second q-axis voltage Vq correspond to the injected second direct current signal.

In one embodiment, both the first direct current signal and the second direct current signal are positive currents on the d-axis. That is to say, the component of the first DC signal and the second DC signal on the d-axis is positive DC, while the component on the q-axis is 0. This can effectively keep the rotor stationary (making the finally measured motor parameters more accurate), and can avoid the risk of demagnetization of the permanent magnet synchronous motor 360.

In step S150, motor parameters are determined based on the received first d-q axis feedback current, first d-q axis voltage, second d-q axis feedback current and second d-q axis voltage. In embodiments where both the first DC signal and the second DC signal are positive currents on the d-axis, the motor parameters may include stator resistance $R_s$, which may be determined, for example, according to the following equation:

$$\mathrm{R}_S = \frac{V_{dc1} - V_{dc2}}{i_{dc1} - i_{dc2}},$$

wherein $V_{dc1}$ is a d-axis voltage in the first d-q axis voltage, $V_{dc2}$ is a d-axis voltage in the second d-q axis voltage, $i_{dc1}$ is a d-axis feedback current value in the first d-q axis feedback current, and $i_{dc2}$ is a d-axis feedback current value in the second d-q axis feedback current, and $i_{dc1} > i_{dc2}$.

After calculating the stator resistance $R_s$, in an embodiment, the permanent magnet flux linkage $\lambda_m$ can be further calculated, wherein the permanent magnet flux linkage $\lambda_m$ can be determined according to the following formula:

$$\lambda_m = \frac{V_{rated} - I_{rated} * R_s}{2 * \pi * f_{rated}},$$

wherein $V_{rated}$ is a rated (working) voltage of the permanent magnet synchronous motor, $I_{rated}$ is a rated current of the permanent magnet synchronous motor, and $f_{rated}$ is a rated frequency of the permanent magnet synchronous motor. Here, the rated voltage, rated current and rated frequency of the permanent magnet synchronous motor are all known quantities, for example, can be obtained from the nameplate of the permanent magnet synchronous motor.

Although not shown in FIG. 1, in one embodiment, the method 1000 may further include: injecting a third signal, the third signal is a sinusoidal signal with a certain frequency and amplitude applied on the d-axis; receiving a third d-axis voltage output by the current regulation module, the third d-axis voltage corresponding to the third signal; and determining a d-axis inductance $L_d$ according to the third d-axis voltage.

In one embodiment, the third signal is represented by the following formula:

$$i_{hd} = i_d + i_{h1} \sin(2 * \pi * f_{h1} * t),$$

wherein $i_{hd}$ is the third signal, $i_d$ is the DC bias on the d-axis(its magnitude is, for example, equal to the d-axis feedback current value $i_{dc2}$ in the second d-q axis feedback current), $i_{h1}$ is an amplitude of the sinusoidal signal, and $f_{h1}$ is a frequency of the sinusoidal signal. In one embodiment, the frequency is 400-600Hz, and this value range is a good balance between the detection accuracy of the motor parameters and the detection requirements of the digital controller----on the one hand, the frequency is much higher than the mechanical frequency (need to be as high as possible to avoid rotor rotation); on the other hand, the frequency takes into account the detection needs of the digital controller (in order to effectively restore the sine wave, the frequency cannot be too high).

Same as the first DC signal and the second DC signal, the third signal is also injected into the input side of the current closed-loop control structure of the motor. Since the third signal is only applied on the d-axis, its component on the q-axis is 0. For example, the d-axis component $i_{dinj}$ injected into the first mixer 312 is equal to $i_{hd}$, while the $i_{qinj}$ injected into the input terminal of the second mixer 314 is 0.

Continuing to refer to FIG. 3, during a third time period (for example, the third time period is immediately after the second time period), a third signal is injected into the input terminals of the first mixer 312 and the second mixer 314 (wherein, $i_{dinj}$ is equal to $i_{hd}$, $i_{qinj}$ is equal to 0), thus the first PI controller 322 outputs the third d-axis voltage $V_d$, the second PI controller 324 outputs the third q-axis voltage $V_q$, and the second coordinate system transformation module 370 outputs the third d-axis feedback current $i_{dfdb}$ and the third q-axis feedback current $i_{qfdb}$ and provides them to the first mixer 312 and the second mixer 314 respectively. That is, the third d-axis voltage $V_d$ corresponds to the injected third signal.

In this embodiment, the d-axis inductance $L_d$ is determined according to the following formula:

$$L_d = \frac{V_{hd}}{2*\pi*f_{h1}*i_{h1}},$$

wherein $V_{hd}$ is the third d-axis voltage.

In one embodiment, the method 1000 further includes: injecting a fourth signal, the fourth signal is a sinusoidal signal with a certain frequency and amplitude applied on the q-axis; receiving the fourth q-axis voltage output by the current regulation module, which corresponds to the fourth signal; and determining the q-axis inductance $L_q$ according to the fourth q-axis voltage.

In one embodiment, the fourth signal is represented by the following formula:

$$i_{hq} = i_{h2}\sin(2*\pi*f_{h2}*t),$$

wherein $i_{hq}$ is the fourth signal, $i_{h2}$ is an amplitude of the sinusoidal signal, and $f_{h2}$ is a frequency of the sinusoidal signal. In one embodiment, the frequency is 400-600Hz, and this value range is a good balance between the detection accuracy of the motor parameters and the detection requirements of the digital controller----on the one hand, the frequency is much higher than the mechanical frequency (the frequency needs to be as high as possible to avoid rotor rotation); on the other hand, the frequency takes into account the detection needs of the digital controller (in order to effectively restore the sine wave, the frequency cannot be too high).

Same as the first DC signal and the second DC signal, the fourth signal is also injected into the input side of the current closed-loop control structure of the motor. Since the fourth signal is only applied on the q-axis, its component on the d-axis is 0. For example, the d-axis component $i_{dinj}$ injected into the first mixer 312 is equal to 0, while the $i_{qinj}$ injected into the input terminal of the second mixer 314 is $i_{hq}$.

Continuing to refer to FIG. 3, during a fourth time period (for example, the fourth time period is immediately after the third time period), a fourth signal is injected into the input terminals of the first mixer 312 and the second mixer 314 (wherein, $i_{dinj}$ is equal to 0, $i_{qinj}$ is equal to $i_{hq}$), thus the first PI controller 322 outputs the fourth d-axis voltage $V_d$, the second PI controller 324 outputs the fourth q-axis voltage $V_q$, and the second coordinate system transformation module 370 outputs the fourth d-axis feedback current $i_{dfdb}$ and the fourth q-axis feedback current $i_{qfdb}$ and provides them to the first mixer 312 and the second mixer 314 respectively. That is, the fourth q-axis voltage $V_q$ corresponds to the injected fourth signal.

In this embodiment, the q-axis inductance $L_q$ is determined according to the following formula:

$$L_q = \frac{V_{hq}}{2*\pi*f_{h2}*i_{h2}},$$

wherein $V_{hq}$ is the fourth q-axis voltage.

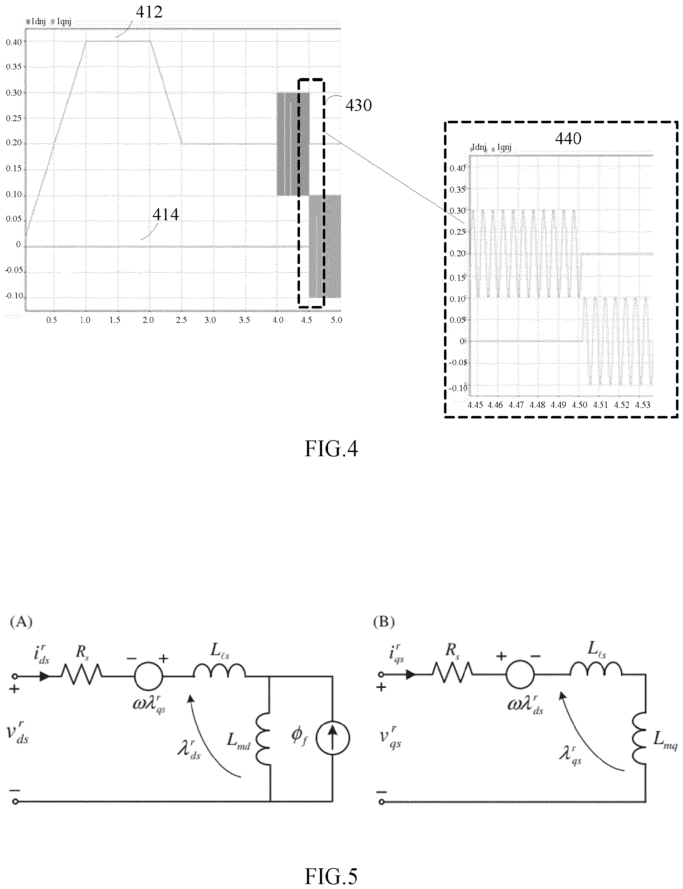

FIG. 4 shows a waveform diagram of signals injected into the d-q axis according to an embodiment of the present invention, wherein the first DC signal, the second DC signal, the third signal and the fourth signal are injected onto the d-q axis in sequence. As shown in FIG. 4, reference numeral 412 represents the component of the injected current signal on the d-axis, namely $i_{dinj}$, and reference numeral 414 represents the component of the injected current signal on the q-axis, namely $i_{qinj}$. In FIG. 4, reference numeral 440 shows an enlarged view of the component on the d-axis and the component on the q-axis of the injected current signal framed by the dotted box 430. It can be seen from the enlarged part that a sine wave (i.e., the third signal) is first injected on the d-axis, and then a sine wave (i.e., the fourth signal) is injected on the q-axis.

In addition, those skilled in the art can easily understand that the method 1000 provided by the foregoing one or more embodiments of the present invention can be implemented by a computer program. For example, the computer program is included in a computer program product, and when the computer program is executed by a processor, the method 1000 for detecting motor parameters of one or more embodiments of the present invention is implemented. For another example, when the computer storage medium (such as a USB flash drive) storing the computer program is connected to the computer, running the computer program can execute the method (1000) for detecting motor parameters of one or more embodiments of the present invention.

FIG. 2 shows a schematic structural diagram of an apparatus for detecting motor parameters 2000 according to an embodiment of the present invention. As shown in FIG. 2, the apparatus 2000 includes: a first receiving device 210, a second receiving device 220, and a determining device 230, wherein the first receiving device 210 is used for receiving a first d-q axis feedback current corresponding to an injected first direct current signal and a first d-q axis voltage output by a current regulation module; the second receiving device 220 is used for receiving a second d-q axis feedback current corresponding to an injected second direct current signal and a second d-q axis voltage output by the current regulation module; and the determining device 230 is used for determining the motor parameters based on the first d-q axis feedback current, the first d-q axis voltage, the second d-q axis feedback current and the second d-q axis voltage.

In one embodiment, the motor is a permanent magnet synchronous motor PMSM, the current regulation module is a PI controller, and both the first DC signal and the second DC signal are positive currents on the d-axis.

For example, continuing to refer to FIG. 3, the motor 360 is a permanent magnet synchronous motor PMSM, and an apparatus for detecting motor parameters is denoted by reference numeral 380. The detection apparatus 380 receives the output d-axis feedback current $i_{dfdb}$ and q-axis feedback current $i_{qfdb}$ from the second coordinate system transformation module 370, and also receives the d-axis voltage $V_d$ from the first PI controller 322, receives the q-axis voltage $V_q$ from the second PI controller 324, and then obtain one or more motor parameters.

In one embodiment, the motor parameters include stator resistance $R_s$. In this embodiment, the determining device 230 is configured to determine the stator resistance $R_s$ according to the following equation:

$$R_s = \frac{V_{dc1} - V_{dc2}}{i_{dc1} - i_{dc2}},$$

wherein $V_{dc1}$ is a d-axis voltage in the first d-q axis voltage, $V_{dc2}$ is a d-axis voltage in the second d-q axis voltage, $i_{dc1}$ is a d-axis feedback current value in the first d-q axis feedback current, and $i_{dc2}$ is a d-axis feedback current value in the second d-q axis feedback current, and $i_{dc1} > i_{dc2}$.

In an embodiment, the motor parameters include the permanent magnet flux linkage $\lambda_m$ and the determining device 230 is configured to determine the permanent magnet flux linkage $\lambda_m$ according to the following formula:

$$\lambda_m = \frac{V_{rated} - I_{rated} * R_s}{2 * \pi * f_{rated}},$$

wherein $V_{rated}$ is a rated voltage of the permanent magnet synchronous motor, $I_{rated}$ is a rated current of the permanent magnet synchronous motor, and $f_{rated}$ is a rated frequency of the permanent magnet synchronous motor.

Although not shown in FIG. 2, in one embodiment, the apparatus 2000 may further include: a third receiving device for receiving the third d-axis voltage output by the current regulation module, the third d-axis voltage corresponding to the injected third signal, and the third signal is a sinusoidal signal with a certain frequency and amplitude applied on the d-axis. The determining device 230 is further configured to determine a d-axis inductance $L_d$ according to the third d-axis voltage.

In one embodiment, the third signal is represented by the following formula:

$$i_{hd} = i_d + i_{h1}\sin(2 * \pi * f_{h1} * t),$$

wherein $i_{hd}$ is the third signal, $i_d$ is the DC bias on the d-axis, $i_{h1}$ is an amplitude of the sinusoidal signal, and $f_{h1}$ is a frequency of the sinusoidal signal.

In this way, the determining device 230 is configured to determine the d-axis inductance $L_d$ according to the following formula:

$$L_d = \frac{V_{hd}}{2 * \pi * f_{h1} * i_{h1}},$$

wherein $V_{hd}$ is the third d-axis voltage.

In one embodiment, the apparatus 2000 further includes: a fourth receiving device for receiving a fourth q-axis voltage output by the current regulation module, the fourth q-axis voltage being corresponding to an injected fourth signal which is a sinusoidal signal with a certain frequency and amplitude applied on the q-axis; and the determining device 230 is further configured to determine the q-axis inductance $L_q$ according to the fourth q-axis voltage.

In one embodiment, the fourth signal is represented by the following formula:

$$i_{hq} = i_{h2}\sin(2 * \pi * f_{h2} * t),$$

wherein $i_{hq}$ is the fourth signal, $i_{h2}$ is an amplitude of the sinusoidal signal, and $f_{h2}$ is a frequency of the sinusoidal signal. In this way, the determining device 230 is configured to determine the q-axis inductance $L_q$ according to the following formula:

$$L_q = \frac{V_{hq}}{2*\pi*f_{h2}*i_{h2}},$$

wherein $V_{hq}$ is the fourth q-axis voltage.

The above apparatus for detecting motor parameters 2000 can be applied to various motor systems, including but not limited to air conditioner compressor systems. In one embodiment, the air conditioner compressor system includes: a permanent magnet synchronous motor; and an apparatus for detecting motor parameters 2000, wherein the apparatus 2000 is used for detecting the motor parameters of the permanent magnet synchronous motor.

In the context of this application, a number of motor parameter calculation formulas are provided. In one or more embodiments, these calculation formulas can be derived based on the d-q axis equivalent circuit model of the permanent magnet synchronous motor as shown in FIG. 5. In FIG. 5, the circuit diagram of the left half shows the equivalent circuit of the d-axis, and the circuit diagram of the right half shows the equivalent circuit of the q-axis. As shown in FIG. 5, for example, in the d-axis equivalent circuit, the stator resistance $R_s$ is coupled in series with the counter electromotive force

$$\omega\lambda^r_{qs}$$

and the leakage inductance $L_{ls}$. Similarly, in the q-axis equivalent circuit, the stator resistance $R_s$ is coupled in series with the counter electromotive force

$$\omega\lambda^r_{ds}$$

and the leakage inductance $L_{ls}$. Those skilled in the art can understand that the sum of the leakage inductance $L_{ls}$ and the d-axis excitation inductance $L_{md}$ is the d-axis inductance $L_d$. Similarly, the sum of the leakage inductance $L_{ls}$ and the q-axis excitation inductance $L_{mq}$ is the q-axis inductance $L_q$.

The above examples mainly illustrate the technical solutions of one or more embodiments of the present invention. Although only some of the embodiments of the invention have been described, those skilled in the art should understand that the invention can be implemented in many other forms without departing from the scope thereof as defined by the appended claims. Therefore, the shown examples and embodiments are to be regarded as illustrative rather than restrictive, and the present invention may cover various modifications and substitutions without departing from the scope of the present invention as defined in the claims.

**Claims**

1. A method (1000) for detecting motor parameters, comprising:

injecting (110) a first direct current signal;
receiving (120) a first d-q axis feedback current corresponding to the first direct current signal and a first d-q axis voltage output by a current regulation module;
injecting (130) a second direct current signal different from the first direct current signal;
receiving (140) a second d-q axis feedback current corresponding to the second direct current signal and a second d-q axis voltage output by the current regulation module; and
determining (150) motor parameters based on the first d-q axis feedback current, the first d-q axis voltage, the second d-q axis feedback current and the second d-q axis voltage.

2. The method of claim 1, wherein the motor is a permanent magnet synchronous motor (360) and the current regulation module is a PI controller.

3. The method of claim 1 or 2, wherein both the first direct current signal and the second direct current signal are positive currents on the d-axis.

4. The method of claim 3, wherein the motor parameters include a stator resistance $R_s$, wherein the stator resistance $R_s$ is determined according to the following formula:

$$R_S = \frac{V_{dc1}-V_{dc2}}{i_{dc1}-i_{dc2}},$$

wherein $V_{dc1}$ is a d-axis voltage in the first d-q axis voltage, $V_{dc2}$ is a d-axis voltage in the second d-q axis voltage, $i_{dc1}$ is a d-axis feedback current value in the first d-q axis feedback current, and $i_{dc2}$ is a d-axis feedback current value in the second d-q axis feedback current, and $i_{dc1}>i_{dc2}$;
optionally
wherein the motor parameters include permanent magnet flux linkage $\lambda_m$, wherein the permanent magnet flux linkage $\lambda_m$ is determined according to the following formula:

$$\lambda_m = \frac{V_{rated}-I_{rated}*R_s}{2*\pi*f_{rated}},$$

wherein $V_{rated}$ is a rated voltage of the permanent magnet synchronous motor, $I_{rated}$ is a rated current of the permanent magnet synchronous motor, and $f_{rated}$ is a rated frequency of the permanent magnet synchronous motor.

5. The method of any preceding claim, further comprising:

injecting a third signal, the third signal being a sinusoidal signal with a certain frequency and amplitude applied on the d-axis; receiving a third d-axis voltage output by the current regulation module, the third d-axis voltage being corresponding to the third signal; and determining a d-axis inductance $L_d$ according to the third d-axis voltage; optionally wherein the third signal is represented by the following formula:

$$i_{hd} = i_d + i_{h1}\sin(2 * \pi * f_{h1} * t),$$

wherein $i_{hd}$ is the third signal, $i_d$ is a DC offset on the d-axis, $i_{h1}$ is an amplitude of the sinusoidal signal, and $f_{h1}$ is a frequency of the sinusoidal signal.

6. The method of claim 5, wherein the d-axis inductance $L_d$ is determined according to the following formula:

$$L_d = \frac{V_{hd}}{2*\pi*f_{h1}*i_{h1}},$$

wherein $V_{hd}$ is the third d-axis voltage.

7. The method of claim 5 or 6, further comprising:

injecting a fourth signal, the fourth signal being a sinusoidal signal with a certain frequency and amplitude applied on the q-axis; receiving a fourth q-axis voltage output by the current regulation module, the fourth q-axis voltage being corresponding to the fourth signal; and determining a q-axis inductance $L_q$ according to the fourth q-axis voltage, wherein the fourth signal is represented by the following formula:

$$i_{hq} = i_{h2}\sin(2 * \pi * f_{h2} * t),$$

wherein $i_{hq}$ is the fourth signal, $i_{h2}$ is an amplitude of the sinusoidal signal, and $f_{h2}$ is a frequency of the sinusoidal signal, wherein the q-axis inductance $L_q$ is determined according to the following formula:

$$L_q = \frac{V_{hq}}{2*\pi*f_{h2}*i_{h2}},$$

wherein $V_{hq}$ is the fourth q-axis voltage.

8. An apparatus (2000, 380) for detecting motor parameters, comprising:

a first receiving device (210) for receiving a first d-q axis feedback current corresponding to an injected first direct current signal and a first d-q axis voltage output by a current regulation module; a second receiving device (220) for receiving a second d-q axis feedback current corresponding to an injected second direct current signal and a second d-q axis voltage output by the current regulation module; and a determining device (230) for determining the motor parameters based on the first d-q axis feedback current, the first d-q axis voltage, the second d-q axis feedback current and the second d-q axis voltage.

9. The apparatus of claim 8, wherein the motor is a permanent magnet synchronous motor (360) and the current regulation module is a PI controller, and both the first direct current signal and the second direct current signal are positive currents on the d-axis.

10. The apparatus of claim 8 or 9, wherein the motor parameters include a stator resistance $R_s$, wherein the determining device (230) is configured to determine the stator resistance $R_s$ according to the following formula:

$$R_s = \frac{V_{dc1}-V_{dc2}}{i_{dc1}-i_{dc2}},$$

wherein $V_{dc1}$ is a d-axis voltage in the first d-q axis voltage, $V_{dc2}$ is a d-axis voltage in the second d-q axis voltage, $i_{dc1}$ is a d-axis feedback current value in the first d-q axis feedback current, and $i_{dc2}$ is a d-axis feedback current value in the second d-q axis feedback current, and $i_{dc1}>i_{dc2}$.

11. The apparatus of claim 10, wherein the motor parameters include permanent magnet flux linkage $\lambda_m$, wherein the determining device (230) is configured to determine the permanent magnet flux linkage $\lambda_m$ according to the following formula:

$$\lambda_m = \frac{V_{rated}-I_{rated}*R_s}{2*\pi*f_{rated}},$$

wherein $V_{rated}$ is a rated voltage of the permanent magnet synchronous motor, $I_{rated}$ is a rated current of the permanent magnet synchronous motor, and $f_{rated}$ is a rated frequency of the permanent magnet synchronous motor.

**12.** The apparatus of any of claims 8 to 11, further comprising:

a third receiving device for receiving a third d-axis voltage output by the current regulation module, the third d-axis voltage being corresponding to the third signal which is a sinusoidal signal with a certain frequency and amplitude applied on the d-axis; and

the determining device (230) is also configured to determine a d-axis inductance $L_d$ according to the third d-axis voltage;

optionally

wherein the third signal is represented by the following formula:

$$i_{hd} = i_d + i_{h1}\sin(2 * \pi * f_{h1} * t),$$

wherein $i_{hd}$ is the third signal, $i_d$ is a DC offset on the d-axis, $i_{h1}$ is an amplitude of the sinusoidal signal, and $f_{h1}$ is a frequency of the sinusoidal signal, and

wherein the determining device (230) is further configured to determine the d-axis inductance $L_d$ according to the following formula:

$$L_d = \frac{V_{hd}}{2 * \pi * f_{h1} * i_{h1}},$$

wherein $V_{hd}$ is the third d-axis voltage.

**13.** The apparatus of claim 12, further comprising:

a fourth receiving device for receiving a fourth q-axis voltage output by the current regulation module, the fourth q-axis voltage being corresponding to an injected fourth signal which is a sinusoidal signal with a certain frequency and amplitude applied on the q-axis; and

the determining device (230) is further configured to determine a q-axis inductance $L_q$ according to the fourth q-axis voltage,

wherein the fourth signal is represented by the following formula:

$$i_{hq} = i_{h2}\sin(2 * \pi * f_{h2} * t),$$

wherein $i_{hq}$ is the fourth signal, $i_{h2}$ is an amplitude of the sinusoidal signal, and $f_{h2}$ is a frequency of the sinusoidal signal,

wherein the q-axis inductance $L_q$ is determined according to the following formula:

$$L_q = \frac{V_{hq}}{2 * \pi * f_{h2} * i_{h2}},$$

wherein $V_{hq}$ is the fourth q-axis voltage.

**14.** A computer program product, comprising a computer program, wherein, when the computer program is executed by a processor, the method (1000) according to any one of claims 1 to 7 is implemented.

**15.** An air-conditioning compressor system, comprising:

a permanent magnet synchronous motor (360); and

the apparatus (2000, 380) according to any one of claims 8 to 13, for detecting motor parameters of the permanent magnet synchronous motor.

**1000**

```
┌─────────────────────┐
│        S110         │
└─────────────────────┘
          │
┌─────────────────────┐
│        S120         │
└─────────────────────┘
          │
┌─────────────────────┐
│        S130         │
└─────────────────────┘
          │
┌─────────────────────┐
│        S140         │
└─────────────────────┘
          │
┌─────────────────────┐
│        S150         │
└─────────────────────┘
```

FIG.1

## 2000

| a first receiving device 210 | a second receiving device 220 |

a determining device 230

FIG.2

FIG.3

FIG.4

FIG.5

| | Europäisches Patentamt European Patent Office Office européen des brevets | **EUROPEAN SEARCH REPORT** | **Application Number** EP 24 17 1760 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ODHANO S A ET AL: "Self-commissioning of interior permanent magnet synchronous motor drives with high-frequency current injection", 2013 IEEE ENERGY CONVERSION CONGRESS AND EXPOSITION, IEEE, 15 September 2013 (2013-09-15), pages 3852-3859, XP032516877, DOI: 10.1109/ECCE.2013.6647211 [retrieved on 2013-10-24] * abstract * * section II.A, and II.B; equation 3; figure 7 * * the whole document * * section II.A; equations 5-8 * ----- | 1-15 | INV. H02P21/16 H02P23/14 |
| X | NGUYEN ANH TAN ET AL: "Parameter Identification of Inverter-Fed Induction Machines at Standstill Based on Signal Injection", 2021 IEEE ENERGY CONVERSION CONGRESS AND EXPOSITION (ECCE), IEEE, 10 October 2021 (2021-10-10), pages 4902-4907, XP034019049, DOI: 10.1109/ECCE47101.2021.9595804 [retrieved on 2021-10-29] * abstract * * section III. A; equation 7; figure 8 * ----- -/-- | 1-15 | TECHNICAL FIELDS SEARCHED (IPC) H02P |

The present search report has been drawn up for all claims

| Place of search | Date of completion of the search | Examiner |
|---|---|---|
| Munich | 10 September 2024 | Koteich, Mohamad |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

**EUROPEAN SEARCH REPORT**

Application Number

EP 24 17 1760

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LASCU CRISTIAN ET AL: "Self-commissioning of electrical parameters for PMSM in sensorless drives", 2015 INTL AEGEAN CONFERENCE ON ELECTRICAL MACHINES & POWER ELECTRONICS (ACEMP), 2015 INTL CONFERENCE ON OPTIMIZATION OF ELECTRICAL & ELECTRONIC EQUIPMENT (OPTIM) & 2015 INTL SYMPOSIUM ON ADVANCED ELECTROMECHANICAL MOTION SYSTEMS (ELECTROMOTION), IEEE, 2 September 2015 (2015-09-02), pages 605-610, XP032877797, DOI: 10.1109/OPTIM.2015.7427054 [retrieved on 2016-03-07] * abstract * * section III. A; equation 5 * | 1-15 | |
| X | US 2017/085202 A1 (YOO ANNO [KR] ET AL) 23 March 2017 (2017-03-23) * abstract; claims 1-3 * * paragraph [0081] - paragraph [0083]; figures 2-5 * | 1-15 | TECHNICAL FIELDS SEARCHED (IPC) |
| A | Li Xinyue ET AL: "Parameter Identification and Controller Optimization for Electrical Drives", , 3 June 2022 (2022-06-03), pages 1-270, XP093201382, Retrieved from the Internet: URL:https://mediatum.ub.tum.de/doc/1613501/1613501.pdf [retrieved on 2024-09-03] * chapter 3; page 57 - page 82 * * equations 3.18-3.22; page 70 * | 1-15 | |

-/--

The present search report has been drawn up for all claims

| Place of search | Date of completion of the search | Examiner |
|---|---|---|
| Munich | 10 September 2024 | Koteich, Mohamad |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Europäisches
Patentamt
European
Patent Office
Office européen
des brevets

Application Number

EP 24 17 1760

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LI TAO ET AL: "UKF-based Offline Estimation of PMSM Magnet Flux Linkage Considering Inverter Dead-time Voltage Error", 2022 IEEE APPLIED POWER ELECTRONICS CONFERENCE AND EXPOSITION (APEC), IEEE, 20 March 2022 (2022-03-20), pages 145-152, XP034125052, DOI: 10.1109/APEC43599.2022.9773526 [retrieved on 2022-05-20] * equation 8, 14 * | 1-15 | |
| A | EP 2 693 628 A1 (SHENZHEN INVT ELECTRIC CO LTD [CN]) 5 February 2014 (2014-02-05) * abstract; claim 1; figure 3 * * paragraph [0045] * | 1-15 | |

TECHNICAL FIELDS SEARCHED     (IPC)

The present search report has been drawn up for all claims

| Place of search | Date of completion of the search | Examiner |
|---|---|---|
| Munich | 10 September 2024 | Koteich, Mohamad |

## ANNEX TO THE EUROPEAN SEARCH REPORT
## ON EUROPEAN PATENT APPLICATION NO.

EP 24 17 1760

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2024

| Patent document cited in search report | | Publication date | Patent family member(s) | | Publication date |
|---|---|---|---|---|---|
| US 2017085202 | A1 | 23-03-2017 | CN | 106953568 A | 14-07-2017 |
| | | | EP | 3145074 A1 | 22-03-2017 |
| | | | ES | 2941910 T3 | 26-05-2023 |
| | | | JP | 6220941 B2 | 25-10-2017 |
| | | | JP | 2017060397 A | 23-03-2017 |
| | | | KR | 20170033578 A | 27-03-2017 |
| | | | US | 2017085202 A1 | 23-03-2017 |
| EP 2693628 | A1 | 05-02-2014 | CN | 102763324 A | 31-10-2012 |
| | | | EP | 2693628 A1 | 05-02-2014 |
| | | | WO | 2012129799 A1 | 04-10-2012 |

EPO FORM P0459

For more details about this annex : see Official Journal of the European Patent Office, No. 12/82